# EUROPEAN PATENT APPLICATION

(11) **EP 0 568 364 A2**
(43) Date of publication of application: **03.11.1993**
(21) Application number: 93303353.2
(22) Date of filing: 28.04.1993
(51) Int. Cl.: H05K 3/12, H05K 1/02

(54) **Plated printed circuit**

(30) Priority: 30.04.1992 JP 137921/92
(71) Applicant: NEC CORPORATION, Tokyo (JP)
(72) Inventor: Miyazaki, Akito, c/o NEC Corporation, Tokyo 108-01 (JP)
(74) Representative: Abnett, Richard Charles

(57) **Abstract**

In a plated printed circuit, a substrate (20) is provided with land patterns (1-14, 101,102) and signal patterns thereon. A solder resist layer is formed on the signal patterns. A symbol pattern (30) indicative of the contour of a part to be mounted is provided on the solder resist layer by silk screen printing. A reference terminal indication line (40) extends out from the symbol pattern toward the land pattern (1) which is to receive a reference terminal provided on the part.

## Description

### BACKGROUND OF THE INVENTION

The present invention relates to a plated printed circuit and, more particularly, to the indication of a reference mounting position on a plated printed circuit for mounting an electronic part having a great number of input/output signal pins.

A prerequisite with a plated printed circuit for mounting a dual-in-line (DIP) type IC (Integrated Circuit) package or similar type of part is that the terminals or pins of the package be accurately. inserted into holes assigned thereto. Various schemes have heretofore been proposed to meet this requirement. Among them, a scheme disclosed in Japanese Patent Laid-Open Publication No. 104498/1988 assigns a square through hole land to the terminal #1 of a DIP type IC and round through hole lands to the other terminals so that they can be distinguished.

On the other hand, it is common practice with a plated printed circuit to form signal patterns on a substrate and then apply a green solder resist to the entire surface of the circuit except for the central portions of the lands. However, the problem with the green solder resist is that it makes it difficult to distinguish the above-stated through hole lands of different shapes, although it protects the signal patterns from corrosion. Therefore, it is impossible to fully eliminate the inadequate insertion of a part.

Another problem with the scheme of Japanese Laid-Open Publication No. 104498/1988 is that the area available between the square through hole land assigned to the terminal #1 and the round through hole land assigned to the terminal #2 for laying signal patterns is narrower than the area available between the other through hole lands. Hence, the number of signal patterns which can be provided between the pins #1 and #2 is limited, compared to signal patterns between the other pins. This critically obstructs high density packaging of parts.

### SUMMARY OF THE INVENTION

It is, therefore, an object of the present invention to provide a plated printed circuit capable of eliminating inaccurate insertion of an IC package or similar part while promoting high density packaging.

A plated printed circuit of the present invention comprises a substrate made of an insulating material, a predetermined number of land patterns each having a hole for inserting a particular pin provided on a part, signal patterns electrically connecting the predetermined number of land patterns, a solder resist layer covering the signal patterns, a symbol pattern printed on the solder resist layer for indicating the contour of the part, the symbol pattern being different in color from the solder resist layer, and a reference terminal indication provided on the solder resist layer by silk screen printing and extending out from the symbol pattern toward one of the predetermined number of land patterns which is assigned to a reference terminal of the part.

### BRIEF DESCRIPTION OF THE DRAWINGS

The above and other objects, features and advantages of the present invention will become more apparent from the following detailed description taken with the accompanying drawings in which:
FIG. 1 is a view showing a conventional plated printed circuit;
FIG. 2 is a view showing a plated printed circuit embodying the present invention; and
FIG. 3 is a view showing an alternative embodiment of the present invention.

### DESCRIPTION OF THE PREFERRED EMBODIMENTS

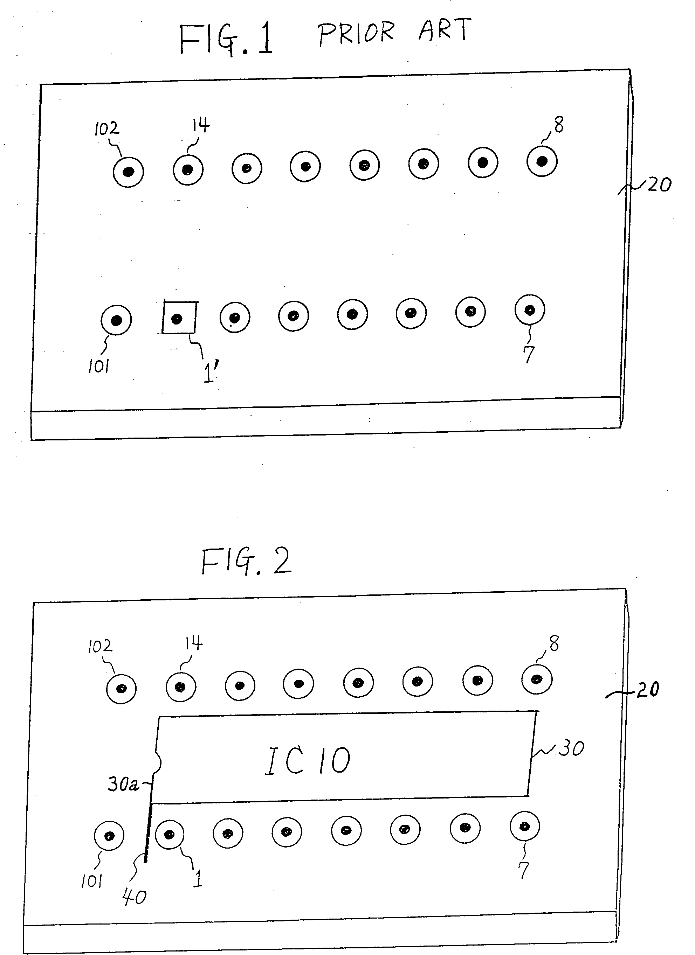

To better understand the present invention, a brief reference will be made to a prior art plated printed circuit disclosed in Japanese Patent Laid-Open Publication No. 104498/1988, shown in FIG. 1. As shown, the plated printed circuit has a substrate 20 provided with through hole land patterns 1'-14 for receiving a 14-terminal DIP type IC. The through hole land pattern 1' assigned to the terminal #1 of the IC is square while the other through hole land patterns 2-14 assigned to the terminals #2 to #14 are circular. There are also provided on the substrate 20 through hole land patterns 101 and 102 for receiving the terminals of another part.

The configuration shown in FIG. 1 has some problems left unsolved, as discussed earlier. Specifically, when the substrate 20 is formed with signal patterns and through hole patterns and then coated with a solder resist, the land configuration for the terminal #1 cannot be easily distinguished from the other land configurations which are identical. Further, as FIG. 1 indicates, the area available between the lands 1' and 2 for laying signal patterns is narrower than the area available between the other lands. Hence, the number of signal patterns which can be provided between the lands 1' and 2 is limited, compared to signal patterns between the other lands.

Referring to FIG. 2, a plated printed circuit embodying the present invention is shown. In FIG. 2, the same constituents as those shown in FIG. 1 are designated by the same reference numerals, and a detailed description will not be made to avoid redundancy. As shown, the plated printed circuit has a through hole land pattern 1 assigned to the pin #1 and provided with the same shape and size as the other through hole land patterns 2-14. Such a configuration allows the same number of signal patterns to be laid between the through hole land patterns 1 and 2 as between the other through hole land patterns.

After necessary through hole land patterns and signal patterns have been provided on the substrate 20, a green solder resist is applied to the plated printed circuit except for the central portions of the through hole land patterns, although not shown in FIG. 2. A symbol pattern 30 is printed on the resulting solder resist layer, not shown, by silk screen printing. The symbol pattern 30 is indicative of the contour of a DIP type IC package. A terminal #1 or reference terminal indication line 4 0 extends out from the periphery 30a of the symbol pattern 30. The reference terminal indication line 40 passes through between the through hole land pattern 1 and a through hole land pattern 101 adjoining the pattern 1 and assigned to a terminal of another IC. It is noteworthy that the reference terminal indication line 40 appears to be "1" as viewed from above.

As stated above, in the illustrative embodiment, the IC symbol pattern 30 is provided on the solder resist layer of the circuit and has a label indicative of a part number. In addition, the reference terminal indication line 40 extends out from the symbol pattern 30 toward the pin #1. A person, therefore, can mount a proper DIP type IC on the circuit as indicated by the label of the symbol pattern 30 and can insert the pins of the IC accurately into the holes of the expected through hole land patterns as guided by the indication line 40 which appears to be "1".

Preferably, the symbol pattern 30 and reference terminal indication line 40 should be colored, for example, white or yellow since they are printed on the green solder resist layer. If desired, the indication line 40 may be different in color even from the symbol pattern 30 to be more conspicuous. Alternatively, the indication line 40 may be made thicker than the line of the symbol pattern 30.

Further, as shown in FIG. 2, the reference terminal indication line 40 should preferably extend to the outside beyond a line tangential to the outer portions of the land patterns 1' and 7. Then, even after the DIP type IC has been packaged on the circuit, the indication line 40 is visible and allows inadequate insertion to be detected before the pins of the IC are soldered.

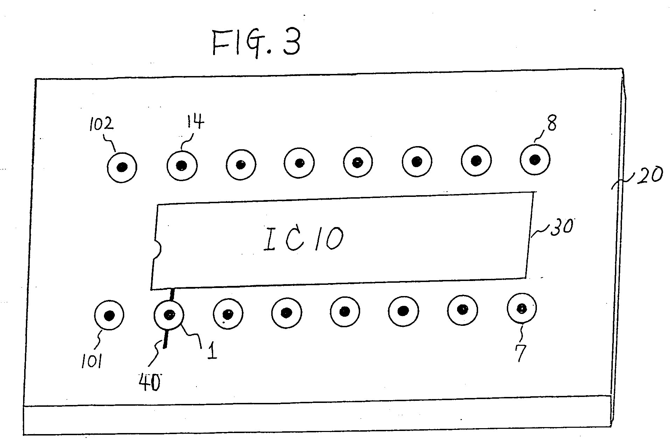

FIG. 3 shows an alternative embodiment of the present invention. This embodiment is essentially similar to the previous embodiment except that the reference terminal indication line 40 extends out by way of the through hole land pattern 1. In this configuration, since the indication line 40 directly adjoins the through hole land pattern 1, it will never occur that a person inserts the terminal #1 in the hole of a land pattern other than that of the land pattern 1.

In summary, it will be seen that the present invention provides a plated printed circuit which eliminates the inadequate insertion of a DIP type IC. This saves time and labor otherwise consumed to remove the DIP type IC from the circuit and then mount it again. While the present invention has been shown and described in relation to a DIP type IC, it is, of course, practicable with any other type of part.

Various modifications will become possible for those skilled in the art after receiving the teachings of the present disclosure without departing from the scope thereof.

## Claims

1. A plated printed circuit comprising:
a substrate (20) made of an insulating material;
a predetermined number of land patterns (1-14, 101,102) each having a hole for inserting a particular pin provided on a part;
signal patterns electrically connecting said predetermined number of land patterns;
a solder resist layer covering said signal patterns; and
a symbol pattern (30) printed on said solder resist layer for indicating a contour of the part, said symbol pattern being different in color from said solder resist layer;
characterised by:
a reference terminal indication (40) provided on said solder resist layer by silk screen printing and extending out from said symbol pattern toward one (1) of said predetermined number of land patterns which is assigned to a reference terminal of the part.

2. A circuit as claimed in claim 1, wherein said reference terminal indication (40) extends to the outside of an area where the part is to be mounted.

3. A circuit as claimed in claim 1, wherein said reference terminal indication (40) extends by way of the one land pattern (1) which is assigned to the reference terminal of the part.

4. A circuit as claimed in claim 1, wherein said reference terminal indication (40) is different in color from both of said symbol pattern and said solder resist layer.

5. A circuit as claimed in claim 1, wherein a part number is printed in said symbol pattern (30) by silk screen printing.

6. A circuit as claimed in claim 1, wherein said reference terminal indication comprises a reference terminal indication line (40).

7. A circuit as claimed in claim 1, wherein said reference terminal indication (40) is silk screen printed on said solder resist layer.
